(19) Europäisches Patentamt
European Patent Office
Office européen des brevets

(11) **EP 1 435 002 B1**

(12) **EUROPEAN PATENT SPECIFICATION**

(45) Date of publication and mention
of the grant of the patent:
**05.10.2011 Bulletin 2011/40**

(21) Application number: **02761502.0**

(22) Date of filing: **26.08.2002**

(51) Int Cl.:
*G01R 21/00* [(2006.01)]   *G06F 17/10* [(2006.01)]

(86) International application number:
**PCT/US2002/027162**

(87) International publication number:
**WO 2003/031996 (17.04.2003 Gazette 2003/16)**

(54) **APPARATUS AND METHOD FOR CALCULATING OF THREE-PHASE POWER FACTOR**

VORRICHTUNG UND VERFAHREN ZUR BERECHNUNG DES DREIPHASEN-LEISTUNGSFAKTORS

APPAREIL ET PROCEDE PERMETTANT DE CALCULER UN FACTEUR DE PUISSANCE TRIPHASEE

(84) Designated Contracting States:
**FR GB**

(30) Priority: **11.10.2001 US 976194**

(43) Date of publication of application:
**07.07.2004 Bulletin 2004/28**

(73) Proprietor: **Trane International Inc.
New York, NY 10019 (US)**

(72) Inventors:
• **VANDERZEE, Joel, C.
La Crosse, WI 54601-6823 (US)**
• **MURRY, Michael, W.
Onalaska, WI 54601 (US)**
• **VOGEL, Richard, L.
Onalaska, Wisconsin 54650 (US)**
• **SHEPECK, Matthew, A.
Holmen, WI 54636 (US)**

(74) Representative: **Treeby, Philip David William et al
R.G.C. Jenkins & Co
26 Caxton Street
London SW1H 0RJ (GB)**

(56) References cited:
**EP-A- 0 498 953    US-A- 5 469 045**

**Description**

BACKGROUND OF THE INVENTION

This disclosed embodiment relates to a three-phase power system such as, for example, a large commercial chiller. More particularly, this disclosed embodiment relates to determining three-phase power factor of a three-phase power system under load and using this three-phase power factor to protect the system from damage caused by such phenomenon as momentary power loss conditions.

In large commercial chillers, three-phase is the power of choice. Three-phase power systems consist of three alternating sources nominally spaced 120 degrees with respect to each other. The spatial separation of these sources set up a cyclic pattern that, when applied to a specific load, sets up a rotating magnetic field. This rotating magnetic field is ideal for allowing motors to turn successfully by converting electrical energy to mechanical energy. In commercial chillers, this mechanical energy is used to turn a refrigerant compressor, one of the critical stages in the refrigerant cycle. Although disclosed in terms of a commercial chiller, the present invention is intended to encompass the calculation of power factor in other applications.

Another type of power source is single-phase. In a single-phase power system, power is delivered to a load via a single alternating source. Even though the source is alternating, it is alternating within itself only and has no point of reference upon which a rotating magnetic field may result. If single-phase power is used to energize motors, a rotating magnetic field needs to be artificially created locally to the motor, usually with a capacitor. Single-phase motors tend to be small in horsepower and have a large ratio of line current to horsepower. Three-phase power has the added advantage of delivering its energy through three sources instead of just one, resulting in smaller wire gauges to deliver the same amount of energy.

Working with three-phase systems presents issues not found in single-phase systems. In single-phase systems, there is a single source voltage and a single current that result when this source voltage is applied to a load. From measuring these two parameters, power factor can be calculated as:

$$\text{Power Factor} = \cos \Phi$$

Where $\Phi$ is the phase angle in which the current lags the voltage.

In working with three-phase systems, the determination of power factor is not a straight-forward calculation involving single entities of current and voltage phase angle. In three-phase systems, three sets of voltages and currents are all interacting with each other. If the three-phase system is symmetrical, that is, if all voltage sources are at exactly the same level and are exactly 120 degrees spatially apart, and the load each source sees is exactly the same, then the angle between the current and voltage of any particular phase of the load may be used to determine the three-phase power factor as:

$$\text{Three-Phase Power Factor} = \cos \Phi_{p}$$

Where $\Phi_{p}$ is the phase angle in which the current lags the voltage of the same configuration, i.e. both current and voltage measurements are taken in-the-delta of the motor.

However, sources of three-phase power systems are rarely balanced (i.e. the levels of the line-to-line voltages are equal, $V_{ab}=V_{bc}=V_{ca}$, as seen by the load) nor is the load itself balanced between the three phases. There is no one angle between a voltage and a current that will indicate true three-phase power factor. In addition, $\Phi_{p}$ is the angle the current lags the voltage for currents and voltages measured in the same configuration. These are, for example, the currents and voltages across the load phase itself (i.e. delta currents and voltages). They also could be the currents and voltages of the source lines (i.e. wye currents and voltages). Typical control modules measure line currents and line-to-line voltages which, since they are not in the same configuration, have a 30 degree offset in the phase angle even if the load is a pure resistor. Here, the true three-phase power factor is unity (the true power factor angle is zero).

Previous designs have attempted to determine three-phase power factor by using one line current and one line-to-line voltage, accounting for the 30 degree difference. This method is only valid for ideally balanced sources and loads, which is rare in reality. The advantage of this method is that it is simple to implement and takes very little computing resources of a processor, memory, and processing power. An inexpensive processor could be used with this method. However, errors in power factor can be as great as 20% under normal unbalanced conditions. This large error gives the customer a false reading regarding what power factor the chiller is performing at, and limits other functions using power factor in their calculations. These other functions include determination of power consumption, surge conditions, and momentary power loss conditions..

True three-phase power factor calculations that are insensitive to the balance of load and source have been accomplished using a high-end processor capable of performing multiple trigonometric functions and digital signal processing. This processor is relatively expensive.

Momentary power losses (MPLs) are short durations of interruptions of the power being supplied to a load such as a motor. These interruptions may be the complete loss of all three phases of incoming power, the loss of one or two phases, or a dip in one, two, or all three phases. These interruptions may be very destructive to the rotating devices being powered. The devices include the motors themselves and/or their loads such as, for example, compressors. The destructiveness of the interruption is dependent on the type of motor and load and the nature and duration of the interruption. For small inertia loads, the motor/load decelerates and accelerates with the interruption with little impact on the reliability of the electromechanical system. For larger inertia motor/loads, the reclosure torques and currents are of a very large level for a longer period of time and impact the reliability of the motor and load. Transient currents may be as high as twelve times full load amps and transient torques may be as high as twelve times full load torque.

Reclosing into momentary power losses may result in large transient torques that could damage motor stator windings, motor shafts, impeller or shaft keyways, the impellers themselves, starter contactors, and branch circuit components. Momentary power losses may also cause the electronic controls to drop out unexpectedly and keep the system off until an operator gets involved. This could mean significant downtime for the system, resulting in a dissatisfied customer.

Momentary power losses may be caused by fault clearing devices being activated as the result of the forces of nature such as lightning strikes or animals coming into contact with the power lines. These interruptions may also be caused by power switching gear where a section of the power supply is moved from one power source to another.

Trying to detect momentary power loss and/or surges based on a single phase voltage and current of a three-phase power system can result in falsely detecting a momentary power loss condition or not detecting a true momentary power loss condition at all.

US Patent 4 751 653 to Junk et al, is directed to a microprocessor based fault detector for identifying phase reversal, phase loss, and power loss in three-phase circuits. US Patent 4 802 053 to Wojtak et al, is directed to a system for sensing the phase of a three-phase AC system and detecting phase reversal, under voltage, and phase unbalance. US Patent 5 058 031 to Swanson et al, is directed to a method of protecting the compressor motor of a refrigeration system using a multi-phase AC power source. US Patent 5 184 063 to Eisenhauer, is directed to a three-phase reversal detection and correction system. US Patent 5 200 682 to Kim et al, is directed to motor current phase delay compensating method and apparatus.

An approach to generating three-phase power factor directly and simply with an inexpensive set up and without having to convert between wye and delta configurations and without having to employ trigonometric calculations or having to measure phase, is desired. It is also desired to use three-phase power factor to protect three-phase power systems and their loads from damage.

US 5 469 045 discloses that a microprocessor is coupled to sense the current and voltage in a power phase at a high sampling rate such as two hundred fifty five (255) times per cycle, and to determine the power factor. The primary of a transformer is coupled across the power lines, and at least two capacitors, forming separate switching paths, are coupled to the secondary of the transformer. High speed switching circuitry under the control of the microprocessor alternately charges and discharges the capacitors, at varying frequencies, to alternately store energy from the power lines when the variable load is returning energy to the power lines, and to supply the stored energy back to the power lines when the variable load is absorbing energy from the power lines. This corrects the power factor since the frequency of the high speed switching circuitry is varied with the varying reactance of the load.

EP 0 498 953 discloses a monolithic integrated circuit as may be used in combination with a plurality of sensors for generating respective sensor output signals, which monolithic integrated circuit includes means for converting each sensor output signal to bit-serial digital format, together with some initial processing circuitry comprising a bit-serial multiply-add processor. This processor includes a bit-serial digital multiplier for multiplying a first digital processor input signal in bit-serial form by a second digital processor input signal to generate a digital product signal, a digital adder for adding a third digital processor input signal to the digital product signal to generate a digital sum signal, and means for supplying a digital processor output signal with bits corresponding to those of said digital sum signal. A memory system provides memory for storing program instructions, memory for storing successive values of the second digital processor input signal, memory for storing successive values of the third digital processor input signal, and memory for storing successive values of the digital processor output signal as written into the memory system. The first digital processor input signal can be selected from among the sensor output signals as converted to bit-serial digital format. The second digital processor input signals applied to the bit-serial multiply-add processor are at least at selected times read from the memory system, as are the third digital processor input signals applied to the bit-serial multiply-add processor. A controller retrieves stored program instructions in a prescribed order from the memory for storing program instructions and generates control signals for controlling at least the reading and writing of the memory system, as well as the selecting of the first digital processor input signal.

BRIEF SUMMARY OF THE INVENTION

Aspects of the present invention are set out in claims 1 and 20.

One aspect of the disclosed embodiment is a three-phase power system capable of sourcing power to a motor that drives a load such as, for example, the compressor of a chiller. The system sources three-phase power to a motor by applying three lines of voltage and current to the motor. Apparent power from a source has components of real power, reactive power, and distortion power. Real power is the power supplied by the source and dissipated by the load. Reactive power is a measure of the energy exchanged between the source and the load without being dissipated. Distortion power is that portion of the apparent power that cannot be used by the load due to distortions in the waveforms of the voltage and current. Power factor is the ratio of real power to apparent power and is, therefore, that fraction of the apparent power actually dissipated by the load. Power factor is also expressed as the cosine of the phase angle by which the current lags the voltage. In a three-phase power system, all three voltages and currents must be considered when determining a meaningful power factor.

Apparatus for determining instantaneous three-phase power factor and true three-phase power factor is provided. "True" means representative of the effective load the power is being sourced to over a line cycle. "Instantaneous" means representative of the load the power is being sourced to at a specific point in time. This apparatus includes a processor that monitors voltage levels and current levels from the source power lines of the three-phase power system. These voltage and current levels are sampled at a predetermined rate and are used to calculate the power factors.

Another aspect of the disclosed embodiment is an apparatus for detecting momentary power loss conditions and other conditions with respect to normal operation. This apparatus includes the processor described above to process the three-phase power factor in order to detect these conditions. This allows the processor to react to the system to prevent damage to the motor and/or load of the system by these conditions.

A method for determining instantaneous three-phase power factor and true three-phase power factor is provided. "True" means representative of the effective load the power is being sourced to over a line cycle. "Instantaneous" means representative of the load the power is being sourced to at a specific point in time. This method includes monitoring voltage levels and current levels from the source power lines of the three-phase power system. These voltage and current levels are sampled at a pre-determined rate and are used to calculate the power factors.

Another aspect of the disclosed embodiment is a method for detecting momentary power loss conditions and other conditions with respect to normal operation. This method includes processing the three-phase power factors in order to detect these conditions. The method is able to react to the detection of these conditions to prevent damage to the motor and/or load of the system by these conditions.

The present invention provides a method of calculating power factor. The method comprises the steps of: determining three sets of currents respectively associated with three motor phases; determining three sets of voltages respectively associated with three motor phases; calculating current phasors and voltage phasors from the sets of currents and sets of voltages; and determining an instantaneous power factor from the calculated current and voltage phasors.

The present invention further provides an arrangement for calculating power factor. The arrangement comprises apparatus determining the magnitude of three sets of currents respectively associated with three motor phases; apparatus determining the magnitude of three sets of voltages respectively associated with three motor phases; apparatus calculating current phasors and voltage phasors from the sets of currents and sets of voltages; and apparatus determining an instantaneous power factor from the calculated current and voltage phasors.

By using the foregoing techniques, a simple, cost-effective approach to monitor the lines of a three-phase power system, calculate three-phase power factors, detect conditions which can cause damage to the system, and prevent such damage from occurring is achieved.

In order that the present invention be more readily understood, specific embodiments thereof will now be described.

BRIEF DESCRIPTION OF THE DRAWINGS

Figure 1 is a schematic block diagram of a three-phase power system made in accordance with the disclosed embodiment, particularly showing the processor that samples the voltage and current levels.

Figure 2 is a diagram of the traditional wye and delta configurations that the three-phase source and load can have in the three-phase power system of Figure 1.

Figure 3 is a modified schematic block diagram of the three-phase power system shown in Figure 1, particularly illustrating certain aspects of the processor including the digitization of the voltage and current levels and algorithms of the disclosed embodiment.

Figure 4 is a flowchart of the momentary power loss algorithm illustrated in Figure 3.

DETAILED DESCRIPTION OF PREFERRED EMBODIMENTS

The features of one embodiment enable a simple, low cost apparatus and method for determining three-phase power factor in a three-phase power system under load. This power factor is then used to detect momentary power loss conditions and other adverse conditions to allow action to be taken in order to protect the motor and load of the three-phase power system from damage when these conditions occur. This is accomplished by using a low-cost processor to sample voltage and current levels from the source lines of the three-phase power system and to perform subsequent calculations of power factor and detection of adverse conditions from these voltage and current levels.

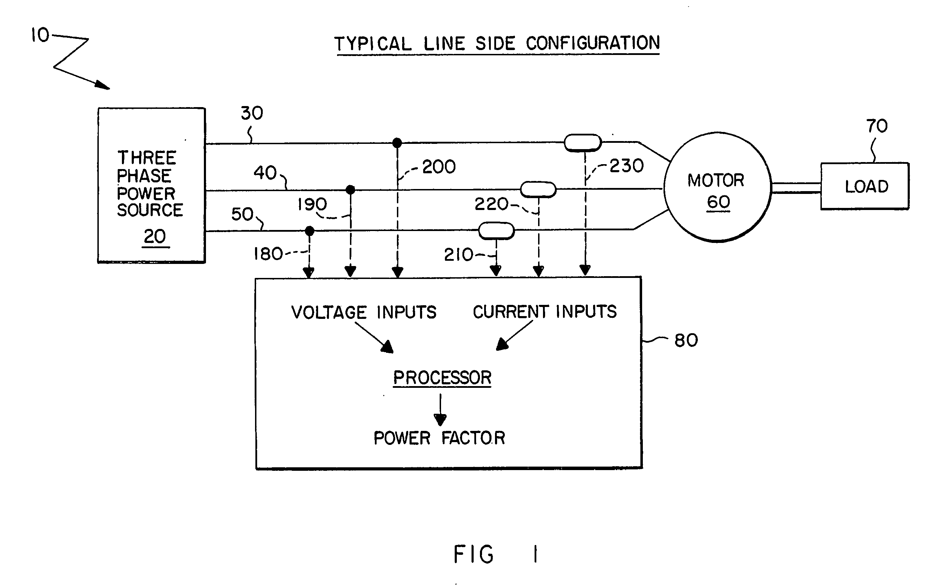

Figure 1 is a schematic block diagram of a three-phase power system 10 made in accordance with the disclosed embodiment. A three-phase source 20 provides three-phase power over source lines 30, 40, and 50 to a three-phase motor 60 that drives a load 70. A processor 80 is configured to sample voltage levels and current levels from the source lines 30, 40, and 50.

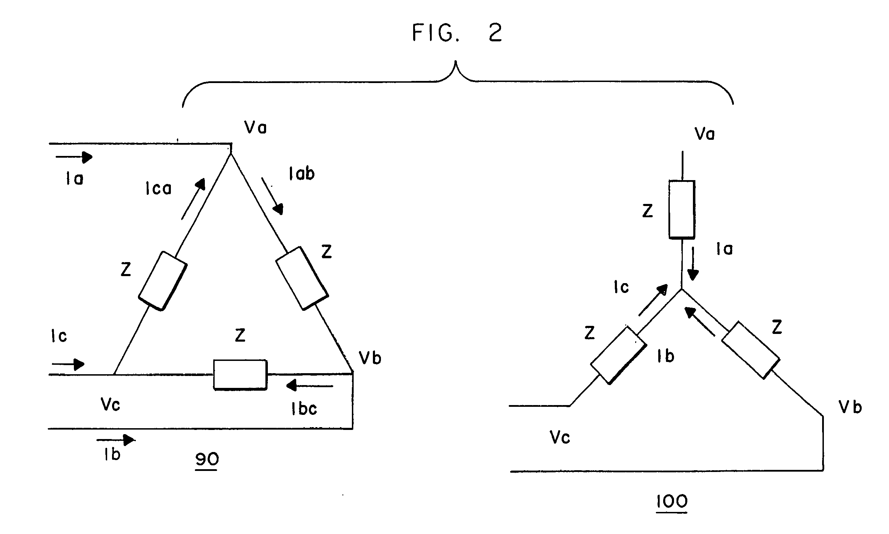

Figure 2 shows the traditional delta configuration 90 and wye configuration 100 of how the source 20 and motor 60 can be configured in a three-phase power system 10. The disclosed embodiment is independent of these configurations and the various combinations thereof.

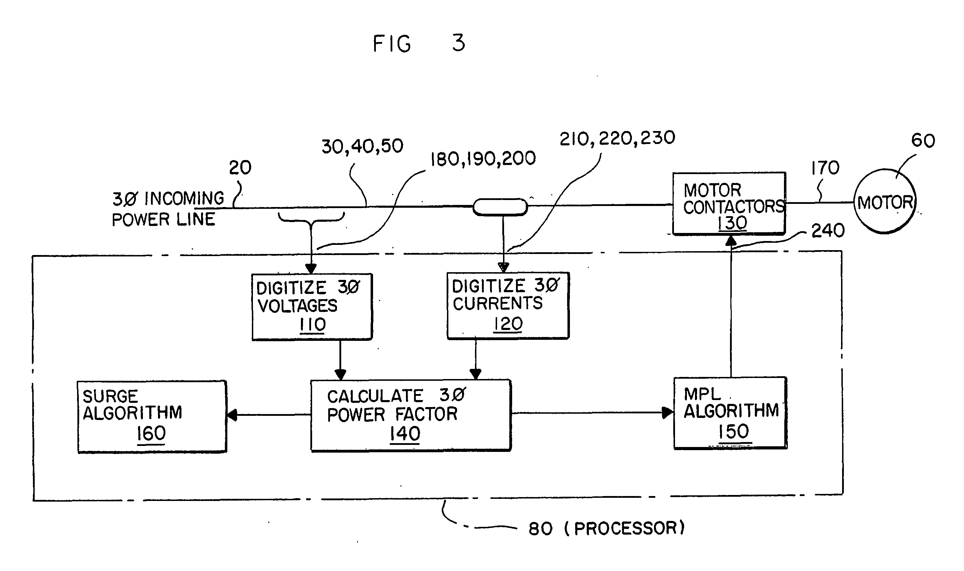

Figure 3 illustrates more detail of the disclosed embodiment including digitizers 110 and 120 of processor 80 for digitizing the voltage and current levels, and motor contactors 130 for connecting and disconnecting the motor 60 from the source lines 30, 40, and 50. The processor 80 also employs several software algorithms. These comprise a three-phase power factor algorithm 140, a momentary power loss (MPL) algorithm 150, and a surge algorithm 160.

The three-phase source 20 is electrically connected to the motor contactors 130 over the source lines 30, 40, and 50. The motor contactors 130 are electrically connected to the three-phase motor 60 over a contactor/motor interface 170 to provide three-phase power to the motor 60. The voltage digitizer 110 in the processor 80 is electrically connected to the source lines 30, 40, and 50 over voltage sampling interfaces 180, 190, and 200 to sample voltage levels. The current digitizer 120 in the processor 80 is electrically connected to the source lines 30, 40, and 50 over current sampling interfaces 210, 220, and 230 to sample current levels. The processor 80 is electrically connected to the motor contactors 130 through a processor/contactor interface 240.

To determine a value of three-phase power factor, the positive and negative levels of voltages and currents are measured from the source lines 30, 40, and 50 by the processor 80, maintaining the positive and negative signs of the measured levels. The measurements may be taken in various combinations of phase and/or line voltage levels and current levels (see Figure 2) such as:

| | |
|---|---|
| first combination: | Vab, Vbc, Vca, Ia, Ib, Ic |
| second combination: | Va, Vb, Vc, Iab, Ibc, Ica |
| third combination: | Vab, Vbc, Vca, Iab, Ibc, Ica |
| fourth combination: | Va, Vb, Vc, Ia, Ib, Ic |

where a, b, and c refer to the three source lines 30, 40, and 50 respectively. For example, Va is the phase voltage level on source line a with respect to a voltage reference. Vab is the line voltage levels between source lines a and b.

The three voltage levels and three current levels are sampled and digitized by the processor 80 and used to calculate values of a voltage phasor and values of a current phasor based on the expected geometric arrangement of the magnetic fields produced by the three phases. The values of real components (Vr and Ir) and the values of imaginary components (Vi and Ii) of the phasors are given by the following equations based on the 120° separation of the three phases:

If Vab, Vbc, and Vca are used:

$$Vr = 3^{0.5} * 0.5 * Vbc \quad \text{and} \quad Vi = 0.5 * (Vab - Vca)$$

If Va, Vb, and Vc are used:

$$Vr = 3^{0.5}*0.5*(Vb-Vc) \text{ and } \quad Vi=Va-0.5*(Vb+Vc)$$

If Ia, Ib, and Ic are used :

$$Ir=3^{0.5}*(Ib-Ic)/3 \qquad \text{and} \quad Ii=Ia$$

If Iab, Ibc, and Ica are used:

$$Ir=3^{0.5}*(2*Ibc-Ica-Iab)/3 \qquad \text{and} \quad Ii=Iab-Ica$$

These equations for Vr, Vi, Ir, and Ii assume the six levels are sampled simultaneously by the processor 80. If the six levels are not sampled simultaneously, the above equations must be modified to compensate for the resulting phase angle discrepancies. Also, for the line-to-line voltage levels and the line current levels, only any two need to be sampled by the processor 80. The third can be calculated from the other two by the processor 80. Additionally, a person of ordinary skill in the art will recognize that other equations may be used by adjusting the correspondence between phasor coordinates and three-phase coordinates.

The value of instantaneous power factor is calculated by the processor 80 using the algorithm 140 as

$$\text{instantaneous power factor} = \cos \Phi$$

where $\Phi$ is the spatial or geometric angle by which the current lags the voltage or the value of instantaneous power factor is calculated as

$$\text{instantaneous power factor} = \cos(\text{angle of the voltage phasor} - \text{angle of}$$

$$\text{the current phasor}).$$

$$= \cos (\theta_V - \theta_I)$$

In other words,

$$\text{power factor} = \text{power/apparent power}$$

$$\text{power} = V \bullet I$$

$$\text{apparent power} = \left| V \right| \bullet \left| I \right|$$

$$= (V_r^2 + V_1^2)^{0.5} \bullet (I_r^2 + I_i^2)^{0.5}$$

$$= [(V_r^2 + V_1^2) \bullet (I_r^I + I_i^2)]^{0.5}$$

The calculation of power is well-known by various calculations but the present invention's calculation of apparent power is unique.

Since,

$$\cos(\theta_V - \theta_I) = \cos(\theta_V) \bullet \cos(\theta_I) + \sin(\theta_V) \bullet \sin(\theta_I)$$

and

$$\cos(\theta_V) = \frac{V_r}{(V_r^2 + V_i^2)^{0.5}}$$

$$\sin(\theta_V) = \frac{V_i}{(V_r^2 + V_i^2)^{0.5}}$$

$$\cos(\theta_I) = \frac{I_r}{(I_r^2 + I_i^2)^{0.5}}$$

$$\sin(\theta_I) = \frac{I_i}{(I_r^2 + I_i^2)^{0.5}}$$

then by substitution

$$\text{instantaneous power factor} = (Vr*Ir + Vi*Ii)/((Vr^2 + Vi^2)*(Ir^2 + Ii^2))^{0.5}$$

This equation is the form used by the processor 80 and the algorithm 140 to calculate a value of instantaneous power factor. This equation uses the levels of the voltages and currents and does not directly use trigonometric functions or phase angles. No conversion between wye and delta configurations is needed.

To calculate a value of true three-phase power factor, the processor 80 samples and calculates multiple instances of values of instantaneous power factor at a pre-determined sampling rate over a pre-determined time interval (such as about but preferably not equal to a line cycle) of the three-phase power system. It is preferable that sampling rate not be equal to a line cycle so that sample locations in a line cycle are distributed in relation to a line cycle period but it is also preferable that the interval over which the samples are averaged is an exact multiple of the line cycles both for 50 Hz and 60 Hz. This provides a representative sampling of the instantaneous power factor. In one embodiment of the invention, this pre-determined sampling rate is every 2.5 msec. A line cycle is typically 20 msec or 16.67 msec corresponding to 50 Hz or 60 Hz source power respectively. The algorithm 140 then averages these values of instantaneous power factor to obtain a value of true three-phase power factor.

This value of true three-phase power factor represents the effective power factor of the load the power is being sourced to and has improved insensitivity to any imbalances of the source, line, or load. This method of calculating power factor is independent of source and load wye and delta configurations. This method is also independent of the configuration in which the voltage and current levels are measured. For example, they may be measured inside or outside a delta motor with the same results. Time intensive sampling of the voltage and current levels is avoided with this method. A processor with a fast clock and higher cost can, therefore, be avoided. These calculations of power factor are highly accurate to give the customer a true sense of the operating point of the system. These calculations of power factor can be used in time critical functions such as detection of momentary power loss (MPL) conditions and detection of surge conditions. With this implementation, expensive instrument grade power factor meters can be avoided. The same simple components and processor capability that are used for normal operation of, for example, a chiller motor can be used for determining power factor with this method.

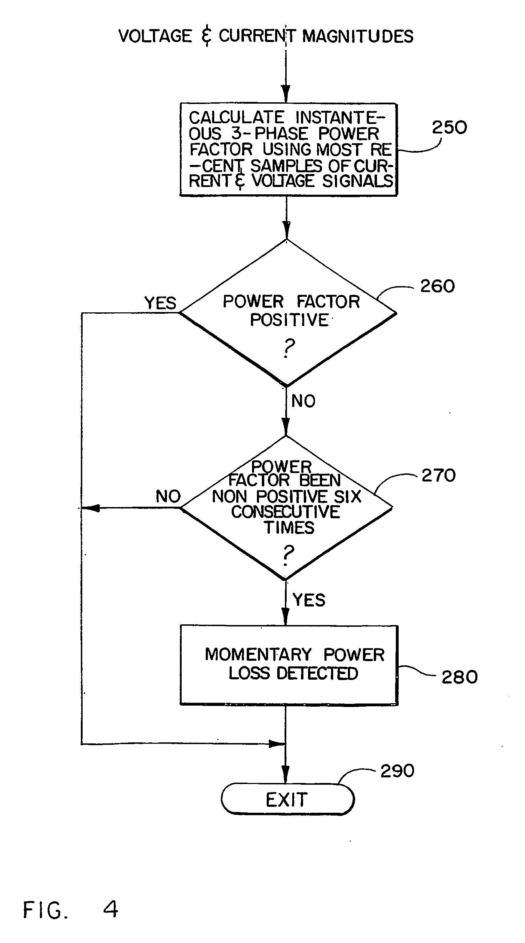

Figure 4 illustrates how the processor 80 uses values of instantaneous power factor to detect a momentary loss of power (MPL) condition using the MPL algorithm 150. The three-phase power system is continuously monitored for an MPL condition. In step 250 of the MPL algorithm 150, the algorithm 140 is called to calculate consecutive instances of values of instantaneous three-phase power factor at a pre-determined sampling rate. In one embodiment of the invention, this sampling rate is every 7.5 msec. In step 260 the values of instantaneous three-phase power factor are checked to determine if they are positive (numerically greater than zero). As long as the instantaneous power factors are positive, an MPL condition does not exist. In step 270, the algorithm 150 checks to see if the last six consecutive values of instantaneous three-phase power factors have been non-positive (numerically less than or equal to zero). If this is the case, then an MPL condition is detected as shown in step 280. The processor 80 then commands the motor contactors 130 to disconnect power from the motor 60. This will prevent damage from occurring to the motor 60 and/or load 70 due to the MPL condition. A pre-determined time interval elapses before the processor 80 attempts to re-connect source power to the motor 60.

Using power factor to determine an MPL condition is beneficial because the power factor represents the true state of the motor 60 at any point in time. This method is very responsive to power line anomalies, allowing the controls to obtain accurate information quickly. This method is also insensitive to DC offsets and non-symmetry of reclosure currents. It is also less sensitive to voltage and current unbalance conditions.

While the invention is described in connection with one embodiment, it will be understood that the invention is not limited to that one embodiment. On the contrary, the invention covers all alternatives, modifications, and equivalents within the scope of the appended claims.

For example, some possible alternatives might include the following described below. The voltage and current levels may not be sampled at the same time. The up to six inputs could be sampled and stored one at a time with a standard analog-to-digital converter that is subsequently read by the processor, or sampled in some other combination.

As another alternative, the three-phase power system may be monitored non-continuously for an MPL condition instead of continuously. For example, monitoring for an MPL condition may be initiated only when some other condition is detected first, such as, for example, a surge condition.

As a further alternative, the various algorithms may be combined in various ways or separated in various ways depending on the exact software implementation desired.

## Claims

1.  An apparatus for generating a data value representative of instantaneous three-phase power factor for a three-phase power system (10), said apparatus comprising:

    a processor (80) for sampling voltage levels and current levels from power source lines (30, 40, 50) of said three-phase power system (10) to form a set of voltage and current levels, said processor (80) being responsive to said set of voltage and current levels to generate said data value representative of said instantaneous three-phase power factor, wherein said processor (80) uses the equation:

$$\text{instantaneous power factor} = \frac{(Vr * Ir + Vi * Ii)}{((Vr^2 + Vi^2) * (Ir^2 + Ii^2))^{0.5}}$$

    to calculate a value of the instantaneous three-phase power factor, wherein Vr and Ir represent the real components and Vi and Ii the imaginary components of the current and voltage phasors which are calculated from said sampled current and voltage levels.

2.  The apparatus of claim 1, wherein said sampling of said voltage levels and current levels from said power source lines (30, 40, 50) of said three- phase power system (10) to form said set of voltage and current levels is done simultaneously by said processor (80).

3.  The apparatus of claim 1, wherein said processor (80) is responsive to a voltage level subset of said set of voltage and current levels to generate real and imaginary component data values representative of a voltage phasor as part of generating said data value representative of said instantaneous three-phase power factor.

4. The apparatus of claim 3, wherein said voltage level subset comprises at least two of:

    a first phase voltage level sampled from a first source line (30) of said power source lines relative to a common voltage reference;
    a second phase voltage level sampled from a second source line (40) of said power source lines relative to a common voltage reference; and
    a third phase voltage level sampled from a third source line (50) of said power source lines relative to a common voltage reference.

5. The apparatus of claim 4, wherein said voltage level subset comprises: a first phase
voltage level sampled from a first source line (30) of said power source lines relative to a common voltage reference;
a second phase voltage level sampled from a second source line (40) of said power source lines relative to a common voltage reference; and
a third phase voltage level sampled from a third source line (50) of said power source lines relative to a common voltage reference.

6. The apparatus of claim 3, wherein said voltage level subset comprises at least two of:

    a first line voltage level sampled from a first source line (30) relative to a second source line of said power source lines;
    a second line voltage level sampled from said second source line (40) relative to a third source line of said power source lines; and
    a third line voltage level sampled from said third source line (50) relative to said first source line of said power source lines.

7. The apparatus of claim 6, wherein said voltage level subset comprises:

    a first line voltage level sampled from a first source line (30) relative to a second source line of said power source lines;
    a second line voltage level sampled from said second source line (40) relative to a third source line of said power source lines; and
    a third line voltage level sampled from said third source line (50) relative to said first source line of said power source lines.

8. The apparatus of claim 1, wherein said processor (80) is responsive to a current level subset of said set of voltage and current levels to generate real and imaginary component data values representative of a current phasor as part of generating said data value representative of said instantaneous three-phase power factor.

9. The apparatus of claim 8, wherein said current level subset comprises at least any two of:

    a first phase current level sampled from a first source line (30) of said power source lines;
    a second phase current level sampled from a second source line (40) of said power source lines; and
    a third phase current level sampled from a third source line (50) of said power source lines.

10. The apparatus of claim 9, wherein said current level subset comprises:

    a first phase current level sampled from a first source line (30) of said power source lines;
    a second phase current level sampled from a second source line (40) of said power source lines; and
    a third phase current level sampled from a third source line (50) of said power source lines.

11. The apparatus of claim 8, wherein said current level subset comprises at least any two of:

    a first line current level sampled from a first source line (30) of said power source lines;
    a second line current level sampled from a second source line (40) of said power source lines; and
    a third line current level sampled from a third source line (50) of said power source lines.

**12.** The apparatus of claim 11, wherein said current level subset comprises:

> a first line current level sampled from a first source line (30) of said power source lines;
> a second line current level sampled from a second source line (40) of said power source lines; and
> a third line current level sampled from a third source line (50) of said power source lines.

**13.** The apparatus of claim 1, further comprising said processor (80) sampling a plurality of sets of voltage and current levels at a predetermined sampling rate over a predetermined time interval to generate a set of instantaneous three-phase power factor data values.

**14.** The apparatus of claim 13, wherein the sampling rate is selected to distribute the sample locations in the line cycle period and to provide representation sampling of instantaneous power factor values.

**15.** The apparatus of claim 13, wherein said processor (80) is responsive to said set of instantaneous three-phase power factor data values to generate a true three-phase power factor data value by filtering said set of instantaneous three-phase power factor data values.

**16.** The apparatus of claim 1, wherein said processor (80) is operable to sample a plurality of sets of voltage and current levels at a predetermined sampling rate to continuously generate a corresponding plurality of instantaneous three-phase power factor data values.

**17.** The apparatus of claim 16, wherein said processor (80) is operable to continuously check if each of a predetermined, consecutive number of most recent data values of said corresponding plurality of instantaneous three-phase power factor data values is less than or equal to zero, i.e. non-positive.

**18.** The apparatus of claim 17, wherein the processor (80) is operable to declare a detection of a momentary power loss condition if each of said predetermined, consecutive number of most recent data values of said corresponding plurality of instantaneous three-phase power factor data values is less than or equal to zero, i.e. non-positive.

**19.** The apparatus of claim 18, wherein said processor (80) is operable to command that a load of said three-phase power system (10) be at least temporarily disconnected from said power source lines (30, 40, 50) when said processor (80) declares said detection of said momentary power loss condition.

**20.** A method for generating a data value representative of instantaneous three-phase power factor in a three-phase power system, said method comprising:

> sampling voltage levels and current levels from power source lines (30, 40, 50) of said three-phase power system (10) to form a set of voltage and current levels; and
> generating said data value representative of said instantaneous three-phase power factor in response to said set of voltage and current levels based on the equation:

$$\text{instantaneous power factor} = \frac{(Vr * Ir + Vi * Ii)}{((Vr^2 + Vi^2) * (Ir^2 + Ii^2))^{0.5}}$$

> to calculate a value of the instantaneous three-phase power factor, wherein Vr and Ir represent the real components and Vi and Ii the imaginary components of the current and voltage phasors which are calculated from said sampled current and voltage levels.

**21.** The method of claim 20, wherein said sampling of said voltage levels and current levels from said power source lines of said three-phase power system (10) to form said set of voltage and current levels is done simultaneously.

**22.** The method of claim 20, further comprising generating real and imaginary component data values representative of a voltage phasor in response to a voltage level subset of said set of voltage and current levels as part of generating said data value representative of said instantaneous three- phase power factor.

**23.** The method of claim 22, wherein said voltage level subset comprises at least any two of:

a first phase voltage level sampled from a first source line (30) of said power source lines relative to a common voltage reference;
a second phase voltage level sampled from a second source line (40) of said power source lines relative to a common voltage reference; and
a third phase voltage level sampled from a third source line (50) of said power source lines relative to a common voltage reference.

**24.** The method of claim 23, wherein said voltage level subset comprises:

a first phase voltage level sampled from a first source line (30) of said power source lines relative to a common voltage reference;
a second phase voltage level sampled from a second source line (40) of said power source lines relative to a common voltage reference; and
a third phase voltage level sampled from a third source line (50) of said power source lines relative to a common voltage reference.

**25.** The method of claim 22, wherein said voltage level subset comprises at least any two of:

a first voltage level sampled from a first source line (30) relative to a second source line of said power source lines;
a second line voltage level sampled from said second source line (40) relative to a third source line of said power source lines; and
a third line voltage level sampled from said third source line (50) relative to said first source line of said power source lines.

**26.** The method of claim 25, wherein said voltage level subset comprises:

a first voltage level sampled from a first source line (30) relative to a second source line of said power source lines;
a second line voltage level sampled from said second source line (40) relative to a third source line of said power source lines; and
a third line voltage level sampled from said third source line (50) relative to said first source line of said power source lines.

**27.** The method of claim 20, further comprising generating real and imaginary component data values representative of a current phasor in response to a current level subset of said set of voltage and current levels as part of generating said data value representative of said instantaneous three- phase power factor.

**28.** The method of claim 27, wherein said current level subset comprises at least any two of:

a first phase current level sampled from a first source line (30) of said power source lines;
a second phase current level sampled from a second source line (40) of said power source lines; and
a third phase current level sampled from a third source line (50) of said power source lines.

**29.** The method of claim 28, wherein said current level subset comprises:

a first phase current level sampled from a first source line (30) of said power source lines;
a second phase current level sampled from a second source line (40) of said power source lines; and
a third phase current level sampled from a third source line (50) of said power source lines.

**30.** The method of claim 27, wherein said current level subset comprises at least any two of:

a first line current level sampled from a first source line (30) of said power source lines;
a second line current level sampled from a second source line (40) of said power source lines; and
a third line current level sampled from a third source line (50) of said power source lines.

**31.** The method of claim 30, wherein said current level subset comprises:

a first line current level sample from a first source line (30) of said power source lines;
a second line current level sampled from a second source line (40) of said power source lines; and
a third line current level sampled from a third source line (50) of said power source lines.

32. The method of claim 20, further comprising sampling a plurality of sets of voltage and current levels at a predetermined sampling rate over a predetermined time interval to generate a set of instantaneous three-phase power factor data values.

33. The method of claim 32, wherein the sampling rate is selected to distribute the sample locations in the line cycle period and to provide representation sampling of instantaneous power factor values.

34. The method of claim 32, further comprising generating a true three-phase power factor data value by filtering said set of instantaneous three-phase power factor data values.

35. The method of claim 20, further comprising sampling a plurality of sets of voltage and current levels at a predetermined sampling rate to continuously generate a corresponding plurality of instantaneous three-phase power factor data values.

36. The method of claim 35, further comprising continuously checking if each of a predetermined, consecutive number of most recent data values of said corresponding plurality of instantaneous three-phase power factor data values is less than or equal to zero, i.e. non-positive.

37. The method of claim 36, further comprising declaring a detection of a momentary power loss condition if each of said predetermined, consecutive number of most recent data values of said corresponding plurality of instantaneous three-phase power factor data values is less than or equal to zero, i.e. non-positive.

38. The method of claim 37, further comprising commanding that a load of said three-phase power system be at least temporarily disconnected from said power source lines when said detection of said momentary power loss condition is declared.

39. A method according to claim 20, wherein the sampling step includes the steps of:

   determining three sets of currents respectively associated with three motor phases;
   determining three sets of voltages respectively associated with three motor phases;

   and wherein the generating step includes the steps of:

   calculating current phasors and voltage phasors from the sets of currents and sets of voltages; and
   determining an instantaneous power factor from the calculated current and voltage phasors.

40. The method of claim 39, including the further step of averaging the instantaneous power factor over a line cycle to determine power factor.

41. An apparatus according to claim 1, further comprising:

   means for determining three sets of currents respectively associated with three motor phases;
   means for determining three sets of voltages respectively associated with three motor phases;
   means for calculating current phasors and voltage phasors from the sets of currents and sets of voltages; and
   means for determining an instantaneous power factor from the calculated current and voltage phasors.

42. The arrangement of claim 41, further including means for averaging the instantaneous power factor over a line cycle to determine power factor.


**Patentansprüche**

1. Vorrichtung zum Erzeugen eines Datenwerts, welcher repräsentativ ist für einen momentanen Dreiphasen-Leistungsfaktor für ein Dreiphasen-Stromversorgungsnetz (10), wobei die Vorrichtung umfasst:

eine Auswerte-Einheit (80) zum Abtasten von Spannungswerten und Stromwerten von Stromversorgungsleitern (30, 40, 50) des Dreiphasen-Stromversorgungsnetzes (10), zum Bilden einer Gruppe von Spannungswerten und Stromwerten, wobei die Auswerte-Einheit (80) auf die Gruppe von Spannungswerten und Stromwerten anspricht, zum Erzeugen des Datenwerts, welcher für den momentanen Dreiphasen-Leistungsfaktor repräsentativ ist, wobei die Auswerte-Einheit (80) die Gleichung verwendet:

$$\text{momentaner Leistungsfaktor} = \frac{(Vr * Ir + Vi * Ii)}{((Vr^2 + Vi^2) * (Ir^2 + Ii^2))^{0.5}}$$

zum Berechnen eines Werts des momentanen Dreiphasen-Leistungsfaktors, wobei Vr und Ir die Realkomponenten und Vi und Ii die Imaginärkomponenten des Stromzeigers und des Spannungszeigers repräsentieren, welche aus den abgetasteten Stromwerten und Spannungswerten berechnet werden.

2.  Vorrichtung nach Anspruch 1, wobei das Abtasten der Spannungswerte und der Stromwerte von den Stromversorgungsleitern (30, 40, 50) des Dreiphasen-Stromversorgungsnetzes (10) zum Bilden der Gruppe von Spannungswerten und Stromwerten durch die Auswerte-Einheit (80) gleichzeitig ausgeführt wird.

3.  Vorrichtung nach Anspruch 1, wobei die Auswerte-Einheit (80) auf eine Untergruppe von Spannungswerten der Gruppe von Spannungswerten und Stromwerten anspricht, zum Erzeugen von Datenwerten für Realkomponenten und Imaginärkomponenten, welche für einen Spannungszeiger repräsentativ sind, als ein Teil des Erzeugens des Datenwerts, welcher für den momentanen Dreiphasen-Leistungsfaktor repräsentativ ist.

4.  Vorrichtung nach Anspruch 3, wobei die Untergruppe von Spannungswerten wenigstens zwei umfasst von:

    einem Spannungswert der ersten Phase, welcher von einem ersten Versorgungsleiter (30) der Stromversorgungsleitung abgetastet wird, relativ zu einer gemeinsamen Spannungsreferenz;
    einem Spannungswert der zweiten Phase, welcher von einem zweiten Versorgungsleiter (40) der Stromversorgungsleitung abgetastet wird, relativ zu einer gemeinsamen Spannungsreferenz; und
    einem Spannungswert der dritten Phase, welcher von einem dritten Versorgungsleiter (50) der Stromversorgungsleitung abgetastet wird, relativ zu einer gemeinsamen Spannungsreferenz.

5.  Vorrichtung nach Anspruch 4, wobei die Untergruppe von Spannungswerten umfasst:

    einen Spannungswert der ersten Phase, welcher von einem ersten Versorgungsleiter (30) der Stromversorgungsleitung abgetastet wird, relativ zu einer gemeinsamen Spannungsreferenz;
    einen Spannungswert der zweiten Phase, welcher von einem zweiten Versorgungsleiter (40) der Stromversorgungsleitung abgetastet wird, relativ zu einer gemeinsamen Spannungsreferenz; und
    einen Spannungswert der dritten Phase, welcher von einem dritten Versorgungsleiter (50) der Stromversorgungsleitung abgetastet wird, relativ zu einer gemeinsamen Spannungsreferenz.

6.  Vorrichtung nach Anspruch 3, wobei die Untergruppe von Spannungswerten wenigstens zwei umfasst von:

    einem Spannungswert des ersten Leiters, welcher von einem ersten Versorgungsleiter (30) abgetastet wird, relativ zu einem zweiten Versorgungsleiter der Stromversorgungsleitung;
    einem Spannungswert des zweiten Leiters, welcher von dem zweiten Versorgungsleiter (40) abgetastet wird, relativ zu einem dritten Versorgungsleiter der Stromversorgungsleitung; und
    einem Spannungswert des dritten Leiters, welcher von dem dritten Versorgungsleiter (50) abgetastet wird, relativ zu dem ersten Versorgungsleiter der Stromversorgungsleitung.

7.  Vorrichtung nach Anspruch 6, wobei die Untergruppe von Spannungswerten umfasst:

    einen Spannungswert des ersten Leiters, welcher von einem ersten versorgungsleiter (30) abgetastet wird, relativ zu einem zweiten Versorgungsleiter der Stromversorgungsleitung;
    einen Spannungswert des zweiten Leiters, welcher von dem zweiten Versorgungsleiter (40) abgetastet wird, relativ zu einem dritten Versorgungsleiter der Stromversorgungsleitung; und
    einen Spannungswert des dritten Leiters, welcher von dem dritten Versorgungsleiter (50) abgetastet wird, relativ zu dem ersten Versorgungsleiter der Stromversorgungsleitung.

8. Vorrichtung nach Anspruch 1, wobei die Auswerte-Einheit (80) auf eine Untergruppe von Stromwerten der Gruppe von Spannungswerten und Stromwerten anspricht, zum Erzeugen von Datenwerten für Realkomponenten und Imaginärkomponenten, welche für einen Stromzeiger als ein Teil des Erzeugens des Datenwerts repräsentativ sind, welcher für den momentanen Dreiphasen-Leistungsfaktor repräsentativ ist.

9. Vorrichtung nach Anspruch 8, wobei die Untergruppe von Stromwerten wenigstens zwei umfasst von:

einem Stromwert der ersten Phase, welcher von einem ersten Versorgungsleiter (30) der Stromversorgungsleitung abgetastet wird;
einem Stromwert der zweiten Phase, welcher von einem zweiten Versorgungsleiter (40) der Stromversorgungsleitung abgetastet wird; und
einem Stromwert der dritten Phase, welcher von einem dritten versorgungsleiter (50) der der Stromversorgungsleitung abgetastet wird.

10. Vorrichtung nach Anspruch 9, wobei die Untergruppe von Stromwerten umfasst:

einen Stromwert der ersten Phase, welcher von einem ersten Versorgungsleiter (30) der Stromversorgungsleitung abgetastet wird;
einen Stromwert der zweiten Phase, welcher von einem zweiten Versorgungsleiter (40) der Stromversorgungsleitung abgetastet wird;
einen Stromwert der dritten Phase, welcher von einem dritten Versorgungsleiter (50) der Stromversorgungsleitung abgetastet wird.

11. Vorrichtung nach Anspruch 8, wobei die Untergruppe von Stromwerten wenigstens zwei umfasst von:

einem Stromwert des ersten Leiters, welcher von einem ersten Versorgungsleiter (30) der Stromversorgungsleitung abgetastet wird;
einem Stromwert des zweiten Leiters, welcher von einem zweiten Versorgungsleiter (40) der Stromversorgungsleitung abgetastet wird; und
einem Stromwert des dritten Leiters, welcher von einem dritten Versorgungsleiter (50) der Stromversorgungsleitung abgetastet wird.

12. Vorrichtung nach Anspruch 11, wobei die Untergruppe von Stromwerten umfasst:

einen Stromwert des ersten Leiters, welcher von einem ersten Versorgungsleiter (30) der Stromversorgungsleitung abgetastet wird;
einen Stromwert des zweiten Leiters, welcher von einem zweiten Versorgungsleiter (40) der Stromversorgungsleitung abgetastet wird; und
einen Stromwert des dritten Leiters, welcher von einem dritten Versorgungsleiter (50) der Stromversorgungsleitung abgetastet wird.

13. Vorrichtung nach Anspruch 1, ferner umfassend die Auswerte-Einheit (80), welche mehrere Gruppen von Spannungs- und Stromwerten abtastet, bei einer vorbestimmten Abtastrate, über ein vorbestimmtes Zeitintervall, zum Erzeugen einer Gruppe von Datenwerten momentaner Dreiphasen-Leistungsfaktoren.

14. Vorrichtung nach Anspruch 13, wobei die Abtastrate derart ausgewählt ist, dass die Zeitpunkte zum Abtasten in der Schwingungsperiode eines Leiters eingeteilt sind, und dass ein repräsentatives Abtasten der Werte momentaner Leistungsfaktoren gegeben ist.

15. Vorrichtung nach Anspruch 13, wobei die Auswerte-Einheit (80) auf die Gruppe von Datenwerten momentaner Dreiphasen-Leistungsfaktoren anspricht, zum Erzeugen eines Datenwerts eines True-Power-Factor-Werts des Dreiphasen-Leistungsfaktors, durch Filtern der Gruppe von Datenwerten momentaner Dreiphasen-Leistungsfaktoren.

16. Vorrichtung nach Anspruch 1, wobei die Auswerte-Einheit (80) zum Abtasten mehrerer Gruppen von Spannungswerten und Stromwerten geeignet ist, bei einer vorbestimmten Abtastrate, zum fortlaufenden Erzeugen entsprechender mehrerer Datenwerte momentaner Dreiphasen-Leistungsfaktoren.

17. Vorrichtung nach Anspruch 16, wobei die Auswerte-Einheit (80) zum fortlaufenden Prüfen geeignet ist, ob jeder von einer vorbestimmten Anzahl aufeinanderfolgender aktueller Datenwerte für die entsprechenden mehreren Datenwerte momentaner Dreiphasen-Leistungsfaktoren kleiner oder gleich null, d.h. nicht positiv, ist.

18. Vorrichtung nach Anspruch 17, wobei die Auswerte-Einheit (80) zum Erklären eines Vorliegens eines Zustands eines momentanen Stromausfalls geeignet ist, wenn jeder von der vorbestimmten Anzahl aufeinanderfolgender aktueller Datenwerte für die entsprechenden mehreren Datenwerte momentaner Dreiphasen-Leistungsfaktoren kleiner oder gleich null, d.h. nicht positiv, ist.

19. Vorrichtung nach Anspruch 18, wobei die Auswerte-Einheit (80) zum Befehlen geeignet ist, dass eine Last an dem Dreiphasen-Stromversorgungsnetz (10) wenigstens temporär von den Strom-Zuleitungen (30, 40, 50) getrennt wird, wenn die Auswerte-Einheit (80) das Vorliegen des Zustands eines momentanen Stromausfalls erklärt.

20. Verfahren zum Erzeugen eines Datenwerts, welcher für einen momentanen Dreiphasen-Leistungsfaktor in einem Dreiphasen-Stromversorgungsnetz repräsentativ ist, wobei das Verfahren umfasst:

Abtasten von Spannungswerten und Stromwerten von Stromversorgungsleitern (30, 40, 50) des Dreiphasen-Stromversorgungsnetzes (10) zum Bilden einer Gruppe von Spannungswerten und Stromwerten; und Erzeugen des Datenwerts, welcher für den momentanen Dreiphasen-Leistungsfaktor repräsentativ ist, in Antwort auf die Gruppe von Spannungswerten und Stromwerten, auf Basis der Gleichung:

$$\text{momentaner Leistungsfaktor} = \frac{(Vr * Ir + Vi * Ii)}{((Vr^2 + Vi^2) * (Ir^2 + Ii^2))^{0.5}}$$

zum Berechnen eines Werts des momentanen Dreiphasen-Leistungsfaktors, wobei $Vr$ und $Ir$ die Realkomponenten und $Vi$ und $Ii$ die Imaginärkomponenten des Stromzeigers und des Spannungszeigers repräsentieren, welche aus den abgetasteten Stromwerten und Spannungswerten berechnet werden.

21. Verfahren nach Anspruch 20, wobei das Abtasten der Spannungswerte und der Stromwerte von den Stromversorgungsleitern des Dreiphasen-Stromnetzes (10) zum Bilden der Gruppe von Spannungswerten und Stromwerten gleichzeitig ausgeführt wird.

22. Verfahren nach Anspruch 20, ferner umfassend Erzeugen von Datenwerten für Realkomponenten und Imaginärkomponenten, welche für einen Spannungszeiger repräsentativ sind, in Antwort auf eine Untergruppe von Spannungswerten der Gruppe von Spannungswerten und Stromwerten, als ein Teil des Erzeugens des Datenwerts, welcher für den momentanen Dreiphasen-Leistungsfaktor repräsentativ ist.

23. Verfahren nach Anspruch 22, wobei die Untergruppe von Spannungswerten wenigstens zwei umfasst von:

einem Spannungswert der ersten Phase, welcher von einem ersten Versorgungsleiter (30) der Stromversorgungsleitung abgetastet wird, relativ zu einer gemeinsamen Spannungsreferenz;
einem Spannungswert der zweiten Phase, welcher von einem zweiten Versorgungsleiter (40) der Stromversorgungsleitung abgetastet wird, relativ zu einer gemeinsamen Spannungsreferenz; und
einem Spannungswert der dritten Phase, welcher von einem dritten Versorgungsleiter (50) der Stromversorgungsleitung abgetastet wird, relativ zu einer gemeinsamen Spannungsreferenz.

24. Verfahren nach Anspruch 23, wobei die Untergruppe von Spannungswerten umfasst:

einen Spannungswert der ersten Phase, welcher von einem ersten Versorgungsleiter (30) der Stromversorgungsleitung abgetastet wird, relativ zu einer gemeinsamen Spannungsreferenz;
einen spannungswert der zweiten Phase, welcher von einem zweiten Versorgungsleiter (40) der Stromversorgungsleitung abgetastet wird, relativ zu einer gemeinsamen Spannungsreferenz; und
einen Spannungswert der dritten Phase, welcher von einem dritten Versorgungsleiter (50) der Stromversorgungsleitung abgetastet wird, relativ zu einer gemeinsamen Spannungsreferenz.

25. Verfahren nach Anspruch 22, wobei die Untergruppe von Spannungswerten wenigstens zwei umfasst von:

einem Spannungswert des ersten Leiters, welcher von einem ersten Versorgungsleiter (30) abgetastet wird, relativ zu einem zweiten Versorgungsleiter der Stromversorgungsleitung;
einem Spannungswert des zweiten Leiters, welcher von dem zweiten Versorgungsleiter (40) abgetastet wird, relativ zu einem dritten Versorgungsleiter der Stromversorgungsleitung; und
einem Spannungswert des dritten Leiters, welcher von dem dritten versorgungsleiter (50) abgetastet wird, relativ zu dem ersten Versorgungsleiter der Strom-Stromversorgungsleitung.

26. Verfahren nach Anspruch 25, wobei die Untergruppe von Spannungswerten umfasst:

einen Spannungswert des ersten Leiters, welcher von einem ersten Versorgungsleiter (30) abgetastet wird, relativ zu einem zweiten Versorgungsleiter der Stromversorgungsleitung;
einen Spannungswert des zweiten Leiters, welcher von dem zweiten Versorgungsleiter (40) abgetastet wird, relativ zu einem dritten Versorgungsleiter der Stromversorgungsleitung; und
einen Spannungswert des dritten Leiters, welcher von dem dritten Versorgungsleiter (50) abgetastet wird, relativ zu dem ersten Versorgungsleiter der Stromversorgungsleitung.

27. Verfahren nach Anspruch 20, ferner umfassend Erzeugen von Datenwerten für Realkomponenten und Imaginärkomponenten, welche für einen Stromzeiger repräsentativ sind, in Antwort auf eine Untergruppe von Stromwerten der Gruppe von Spannungswerten und Stromwerten, als ein Teil des Erzeugens des Datenwerts, welcher für den momentanen Dreiphasen-Leistungsfaktor repräsentativ ist.

28. Verfahren nach Anspruch 27, wobei die Untergruppe von Stromwerten wenigstens zwei umfasst von:

einem Stromwert der ersten Phase, welcher von einem ersten versorgungsleiter (30) der Stromversorgungsleitung abgetastet wird;
einem Stromwert der zweiten Phase, welcher von einem zweiten versorgungsleiter (40) der Stromversorgungsleitung abgetastet wird; und
einem Stromwert der dritten Phase, welcher von einer dritten Versorgungsleiter (50) der Stromversorgungsleitung abgetastet wird.

29. Verfahren nach Anspruch 28, wobei die Untergruppe von Stromwerten umfasst:

einen Stromwert der ersten Phase, welcher von einem ersten Versorgungsleiter (30) der Stromversorgungsleitung abgetastet wird;
einen Stromwert der zweiten Phase, welcher von einem zweiten Versorgungsleiter (40) der Stromversorgungsleitung abgetastet wird;
einen Stromwert der dritten Phase, welcher von einem dritten Versorgungsleiter (50) der Stromversorgungsleitung abgetastet wird.

30. Verfahren nach Anspruch 27, wobei die Untergruppe von Stromwerten wenigstens zwei umfasst von:

einem Stromwert des ersten Leiters, welcher von einem ersten Versorgungsleiter (30) der Stromversorgungsleitung abgetastet wird;
einem Stromwert des zweiten Leiters, welcher von einem zweiten Versorgungsleiter (40) der Stromversorgungsleitung abgetastet wird; und
einem Stromwert des dritten Leiters, welcher von einem dritten Versorgungsleiter (50) der Stromversorgungsleitung abgetastet wird.

31. Verfahren nach Anspruch 30, wobei die Untergruppe von Stromwerten umfasst:

einen Stromwert des ersten Leiters, welcher von einem ersten Versorgungsleiter (30) der Stromversorgungsleitung abgetastet wird;
einen Stromwert des zweiten Leiters, welcher von einem zweiten Versorgungsleiter (40) der Stromversorgungsleitung abgetastet wird; und
einen Stromwert des dritten Leiters, welcher von einem dritten versorgungsleiter (50) der Stromversorgungsleitung abgetastet wird.

32. Verfahren nach Anspruch 20, ferner umfassend Abtasten mehrerer Gruppen von Spannungs- und Stromwerten, bei einer vorbestimmten Abtastrate, über ein vorbestimmtes Zeitintervall, zum Erzeugen einer Gruppe von Datenwerten momentaner Dreiphasen-Leistungsfaktoren.

33. Verfahren nach Anspruch 32, wobei die Abtastrate derart ausgewählt wird, dass die Zeitpunkte zum Abtasten in der Schwingungsperiode eines Leiters eingeteilt sind, und dass ein repräsentatives Abtasten der Werte momentaner Leistungsfaktoren gegeben ist.

34. Verfahren nach Anspruch 32, ferner umfassend Erzeugen eines Datenwerts eines True-Power-Factor-Werts des Dreiphasen-Leistungsfaktors, durch Filtern der Gruppe von Datenwerten momentaner Dreiphasen-Leistungsfaktoren.

35. Verfahren nach Anspruch 20, ferner umfassend Abtasten mehrerer Gruppen von Spannungswerten und Stromwerte, bei einer vorbestimmten Abtastrate, zum fortlaufenden Erzeugen entsprechender mehrerer Datenwerte momentaner Dreiphasen-Leistungsfaktoren.

36. Verfahren nach Anspruch 35, ferner umfassend fortlaufendes Prüfen, ob jeder von einer vorbestimmten Anzahl aufeinanderfolgender aktueller Datenwerte für die entsprechenden mehreren Datenwerte momentaner Dreiphasen-Leistungsfaktoren kleiner oder gleich null, d.h. nicht positiv, ist.

37. Verfahren nach Anspruch 36, ferner umfassend Erklären eines vorliegens eines Zustands eines momentanen Stromausfalls, wenn jeder von der vorbestimmten Anzahl aufeinanderfolgender neuester Datenwerte für die entsprechenden mehreren Datenwerte momentaner Dreiphasen-Leistungsfaktoren kleiner oder gleich null, d.h. nicht positiv, ist.

38. Verfahren nach Anspruch 37, ferner umfassend Befehlen, dass eine Last an dem Dreiphasen-Stromversorgungsnetz (10) wenigstens temporär von den Stromversorgungsleitungen getrennt wird, wenn das Vorliegen des Zustands eines momentanen Stromausfalls erklärt wird.

39. Verfahren nach Anspruch 20, wobei der Schritt des Abtastens die Schritte umfasst:

Bestimmen von drei Gruppen von Strömen, welche jeweils drei Motorphasen zugeordnet sind;
Bestimmen von drei Gruppen von Spannungen, welche jeweils drei Motorphasen zugeordnet sind, und wobei der Schritt des Erzeugens den Schritt umfasst:

Berechnen von Stromzeigern und Spannungszeigern aus den Gruppen von Strömen und den Gruppen von Spannungen; und
Bestimmen eines momentanen Leistungsfaktors aus den berechneten Stromzeigern und Spannungszeigern.

40. Verfahren nach Anspruch 39, umfassend den weiteren Schritt des mittelns des momentanen Leistungsfaktors über eine Schwingungsperiode eines Leiters, zum Bestimmen des Leistungsfaktors.

41. Vorrichtung nach Anspruch 1, ferner umfassend:

Mittel zum Bestimmen von drei Gruppen von Strömen, welche jeweils drei Motorphasen zugeordnet sind;
Mittel zum Bestimmen von drei Gruppen von Spannungen, welche jeweils drei Motorphasen zugeordnet sind;
Mittel zum Berechnen von Stromzeigern und Spannungszeigern aus den Gruppen von Strömen und den Gruppen von Spannungen; und
Mittel zum Bestimmen eines momentanen Leistungsfaktors aus den berechneten Stromzeigern und Spannungszeigern.

42. Anordnung nach Anspruch 41, ferner umfassend Mittel zum Mitteln des momentanen Leistungsfaktors über eine Schwingungsperiode eines Leiters zum Bestimmen des Leistungsfaktors.

**Revendications**

1. Appareil pour générer une valeur de données représentative d'un facteur de puissance triphasée instantané pour un système de puissance triphasé (10), ledit appareil comprenant :

un processeur (80) pour échantillonner des niveaux de tension et des niveaux de courant à partir de lignes de source d'alimentation (30, 40, 50) dudit système de puissance triphasé (10) de façon à former un jeu de niveaux de tension et de courant, ledit processeur (80) réagissant audit jeu de niveaux de tension et de courant en générant ladite valeur de données représentative dudit facteur de puissance triphasée instantané, dans lequel ledit processeur (80) utilise l'équation :

$$\text{facteur de puissance instantané} = \frac{(Vr * Ir + Vi * Ii)}{((Vr^2 + Vi^2) * (Ir^2 Ii^2))^{0,5}}$$

afin de calculer une valeur du facteur de puissance triphasée instantané, dans laquelle Vr et Ir représentent les composantes réelles et Vi et Ii représentent les composantes imaginaires des phaseurs de tension et de courant qui sont calculés à partir desdits niveaux de tension et de courant échantillonnés.

2. Appareil selon la revendication 1, dans lequel ledit échantillonnage desdits niveaux de tension et desdits niveaux de courant à partir desdites lignes de source d'alimentation (30, 40, 50) dudit système de puissance triphasé (10) afin de former ledit jeu de niveaux de tension et de courant est effectué simultanément par ledit processeur (80).

3. Appareil selon la revendication 1, dans lequel ledit processeur (80) réagit à un sous-jeu de niveaux de tension dudit jeu et de niveaux de tension et de courant en générant des valeurs de données de composantes réelles et imaginaires représentatives d'un phaseur de tension à titre de partie d'une génération de ladite valeur de données représentative dudit facteur de puissance triphasée instantané.

4. Appareil selon la revendication 3, dans lequel ledit sous-jeu de niveaux de tension comprend au moins deux parmi :

un premier niveau de tension de phase échantillonné à partir d'une première ligne de source (30) desdites lignes de source d'alimentation par rapport à une référence de tension commune ;
un deuxième niveau de tension de phase échantillonné à partir d'une deuxième ligne de source (40) desdites lignes de source d'alimentation par rapport à une référence de tension commune ; et
un troisième niveau de tension de phase échantillonné à partir d'une troisième ligne de source (50) desdites lignes de source d'alimentation par rapport à une référence de tension commune.

5. Appareil selon la revendication 4, dans lequel ledit sous-jeu de niveaux de tension comprend :

un premier niveau de tension de phase échantillonné à partir d'une première ligne de source (30) desdites lignes de source d'alimentation par rapport à une référence de tension commune ;
un deuxième niveau de tension de phase échantillonné à partir d'une deuxième ligne de source (40) desdites lignes de source d'alimentation par rapport à une référence de tension commune ; et
un troisième niveau de tension de phase échantillonné à partir d'une troisième ligne de source (50) desdites lignes de source d'alimentation par rapport à une référence de tension commune.

6. Appareil selon la revendication 3, dans lequel ledit sous-jeu de niveaux de tension comprend au moins deux parmi :

un premier niveau de tension de ligne échantillonné à partir d'une première ligne de source (30) par rapport à une deuxième ligne de source desdites lignes de source d'alimentation ;
un deuxième niveau de tension de ligne échantillonné à partir de ladite deuxième ligne de source (40) par rapport à une troisième ligne de source desdites lignes de source d'alimentation ; et
un troisième niveau de tension de ligne échantillonné à partir de ladite troisième ligne de source (50) par rapport à ladite première ligne de source desdites lignes de source d'alimentation.

7. Appareil selon la revendication 6, dans lequel ledit sous-jeu de niveaux de tension comprend :

un premier niveau de tension de ligne échantillonné à partir d'une première ligne de source (30) par rapport à une deuxième ligne de source desdites lignes de source d'alimentation ;
un deuxième niveau de tension de ligne échantillonné à partir de ladite deuxième ligne de source (40) par rapport à une troisième ligne de source desdites lignes de source d'alimentation ; et
un troisième niveau de tension de ligne échantillonné à partir de ladite troisième ligne de source (50) par rapport à ladite première ligne de source desdites lignes de source d'alimentation.

**8.** Appareil selon la revendication 1, dans lequel ledit processeur (80) réagit à un sous-jeu de niveaux de courant dudit jeu de niveaux de tension et de courant en générant des valeurs de données de composantes réelles et imaginaires représentatives d'un phaseur de courant à titre de partie d'une génération de ladite valeur de données représentative dudit facteur de puissance triphasée instantané.

**9.** Appareil selon la revendication 8, dans lequel ledit sous-jeu de niveaux de courant comprend au moins deux quelconques parmi :

un premier niveau de courant de phase échantillonné à partir d'une première ligne de source (30) desdites lignes de source d'alimentation ;
un deuxième niveau de courant de phase échantillonné à partir d'une deuxième ligne de source (40) desdites lignes de source d'alimentation ; et
un troisième niveau de courant de phase échantillonné à partir d'une troisième ligne de source (50) desdites lignes de source d'alimentation.

**10.** Appareil selon la revendication 9, dans lequel ledit sous-jeu de niveaux de courant comprend :

un premier niveau de courant de phase échantillonné à partir d'une première ligne de source (30) desdites lignes de source d'alimentation ;
un deuxième niveau de courant de phase échantillonné à partir d'une deuxième ligne de source (40) desdites lignes de source d'alimentation ; et
un troisième niveau de courant de phase échantillonné à partir d'une troisième ligne de source (50) desdites lignes de source d'alimentation.

**11.** Appareil selon la revendication 8, dans lequel ledit sous-jeu de niveaux de courant comprend au moins deux quelconques parmi :

un premier niveau de courant de ligne échantillonné à partir d'une première ligne de source (30) desdites lignes de source d'alimentation ;
un deuxième niveau de courant de ligne échantillonné à partir d'une deuxième ligne de source (40) desdites lignes de source d'alimentation ; et
un troisième niveau de courant de ligne échantillonné à partir d'une troisième ligne de source (50) desdites lignes de source d'alimentation.

**12.** Appareil selon la revendication 11, dans lequel ledit sous-jeu de niveaux de courant comprend :

un premier niveau de courant de ligne échantillonné à partir d'une première ligne de source (30) desdites lignes de source d'alimentation ;
un deuxième niveau de courant de ligne échantillonné à partir d'une deuxième ligne de source (40) desdites lignes de source d'alimentation ; et
un troisième niveau de courant de ligne échantillonné à partir d'une troisième ligne de source (50) desdites lignes de source d'alimentation.

**13.** Appareil selon la revendication 1, comprenant de plus ledit processeur (80) qui échantillonne une pluralité de jeux de niveaux de tension et de courant à une fréquence d'échantillonnage prédéterminée sur un intervalle de temps prédéterminé de façon à générer un jeu de valeurs de données de facteur de puissance triphasée instantané.

**14.** Appareil selon la revendication 13, dans lequel la fréquence d'échantillonnage est sélectionnée de façon à distribuer les emplacements d'échantillon dans la période de cycle de ligne et à produire un échantillonnage de représentation de valeurs de facteur de puissance instantané.

**15.** Appareil selon la revendication 13, dans lequel ledit processeur (80) réagit audit jeu de valeurs de données de facteur de puissance triphasée instantané en générant une valeur de données de facteur de puissance triphasée réel par filtrage dudit jeu de valeurs de données de facteur de puissance triphasée instantané.

**16.** Appareil selon la revendication 1, dans lequel ledit processeur (80) peut fonctionner de façon à échantillonner une pluralité de jeux de niveaux de tension et de courant à une fréquence d'échantillonnage prédéterminée de façon à générer de façon continue une pluralité correspondante de valeurs de données de facteur de puissance triphasée instantané.

**17.** Appareil selon la revendication 16, dans lequel ledit processeur (80) peut fonctionner de façon à vérifier de façon continue si chacune d'un nombre consécutif prédéterminé de valeurs de données les plus récentes de ladite pluralité correspondante de valeurs de données de facteur de puissance triphasée instantané est inférieure ou égale à zéro, ou, autrement dit, non positive.

**18.** Appareil selon la revendication 17, dans lequel le processeur (80) peut fonctionner de façon à déclarer une détection d'une condition de perte de puissance momentanée si chacun dudit nombre consécutif prédéterminé de valeurs de données les plus récentes de ladite pluralité correspondante de valeurs de données de facteur de puissance triphasée instantané est inférieure ou égale à zéro, ou, autrement dit, non positive.

**19.** Appareil selon la revendication 18, dans lequel ledit processeur (80) peut fonctionner de façon à ordonner qu'une charge dudit système de puissance triphasé (10) soit au moins temporairement déconnectée desdites lignes de source d'alimentation (30, 40, 50) lorsque ledit processeur (80) déclare ladite détection de ladite condition de perte de puissance momentanée.

**20.** Procédé pour générer une valeur de données représentative d'un facteur de puissance triphasée instantané dans un système de puissance triphasé, ledit procédé comprenant :

l'échantillonnage de niveaux de tension et de niveaux de courant à partir de lignes de source d'alimentation (30, 40, 50) dudit système de puissance triphasé (10) de façon à former un jeu de niveaux de tension et de courant ; et
la génération de ladite valeur de données représentative dudit facteur de puissance triphasée instantané en réponse audit jeu de niveaux de tension et de courant en fonction de l'équation :

$$\text{facteur de puissance instantané} = \frac{(Vr * Ir + Vi * Ii)}{((Vr^2 + Vi^2) * (Ir^2 Ii^2))^{0,5}}$$

afin de calculer une valeur du facteur de puissance triphasée instantané, dans laquelle Vr et Ir représentent les composantes réelles et Vi et Ii représentent les composantes imaginaires des phaseurs de tension et de courant qui sont calculés à partir desdits niveaux de tension et de courant échantillonnés.

**21.** Procédé selon la revendication 20, dans lequel ledit échantillonnage desdits niveaux de tension et desdits niveaux de courant à partir desdites lignes de source d'alimentation dudit système de puissance triphasé (10) afin de former ledit jeu de niveaux de tension et de courant est effectué simultanément.

**22.** Procédé selon la revendication 20, comprenant de plus la génération de valeurs de données de composantes réelles et imaginaires représentatives d'un phaseur de tension en réponse à un sous-jeu de niveaux de tension dudit jeu de niveaux de tension et de courant à titre de partie d'une génération de ladite valeur de données représentative dudit facteur de puissance triphasée instantané.

**23.** Procédé selon la revendication 22, dans lequel ledit sous-jeu de niveaux de tension comprend au moins deux quelconques parmi :

un premier niveau de tension de phase échantillonné à partir d'une première ligne de source (30) desdites lignes de source d'alimentation par rapport à une référence de tension commune ;
un deuxième niveau de tension de phase échantillonné à partir d'une deuxième ligne de source (40) desdites lignes de source d'alimentation par rapport à une référence de tension commune ; et
un troisième niveau de tension de phase échantillonné à partir d'une troisième ligne de source (50) desdites lignes de source d'alimentation par rapport à une référence de tension commune.

**24.** Procédé selon la revendication 23, dans lequel ledit sous-jeu de niveaux de tension comprend :

un premier niveau de tension de phase échantillonné à partir d'une première ligne de source (30) desdites lignes de source d'alimentation par rapport à une référence de tension commune ;
un deuxième niveau de tension de phase échantillonné à partir d'une deuxième ligne de source (40) desdites lignes de source d'alimentation par rapport à une référence de tension commune ; et
un troisième niveau de tension de phase échantillonné à partir d'une troisième ligne de source (50) desdites lignes de source d'alimentation par rapport à une référence de tension commune.

25. Procédé selon la revendication 22, dans lequel ledit sous-jeu de niveaux de tension comprend au moins deux quelconques parmi :

un premier niveau de tension échantillonné à partir d'une première ligne de source (30) par rapport à une deuxième ligne de source desdites lignes de source d'alimentation ;
un deuxième niveau de tension de ligne échantillonné à partir de ladite deuxième ligne de source (40) par rapport à une troisième ligne de source desdites lignes de source d'alimentation ; et
un troisième niveau de tension de ligne échantillonné à partir de ladite troisième ligne de source (50) par rapport à ladite première ligne de source desdites lignes de source d'alimentation.

26. Procédé selon la revendication 25, dans lequel ledit sous-jeu de niveaux de tension comprend :

un premier niveau de tension échantillonné à partir d'une première ligne de source (30) par rapport à une deuxième ligne de source desdites lignes de source d'alimentation ;
un deuxième niveau de tension de ligne échantillonné à partir de ladite deuxième ligne de source (40) par rapport à une troisième ligne de source desdites lignes de source d'alimentation ; et
un troisième niveau de tension de ligne échantillonné à partir de ladite troisième ligne de source (50) par rapport à ladite première ligne de source desdites lignes de source d'alimentation.

27. Procédé selon la revendication 20, comprenant de plus la génération de valeurs de données de composantes réelles et imaginaires représentatives d'un phaseur de courant en réponse à un sous-jeu de niveaux de courant dudit jeu de niveaux de tension et de courant à titre de partie d'une génération de ladite valeur de données représentative dudit facteur de puissance triphasée instantané.

28. Procédé selon la revendication 27, dans lequel ledit sous-jeu de niveaux de courant comprend au moins deux quelconques parmi :

un premier niveau de courant de phase échantillonné à partir d'une première ligne de source (30) desdites lignes de source d'alimentation ;
un deuxième niveau de courant de phase échantillonné à partir d'une deuxième ligne de source (40) desdites lignes de source d'alimentation ; et
un troisième niveau de courant de phase échantillonné à partir d'une troisième ligne de source (50) desdites lignes de source d'alimentation.

29. Procédé selon la revendication 28, dans lequel ledit sous-jeu de niveaux de courant comprend :

un premier niveau de courant de phase échantillonné à partir d'une première ligne de source (30) desdites lignes de source d'alimentation ;
un deuxième niveau de courant de phase échantillonné à partir d'une deuxième ligne de source (40) desdites lignes de source d'alimentation ; et
un troisième niveau de courant de phase échantillonné à partir d'une troisième ligne de source (50) desdites lignes de source d'alimentation.

30. Procédé selon la revendication 27, dans lequel ledit sous-jeu de niveaux de courant comprend au moins deux quelconques parmi :

un premier niveau de courant de ligne échantillonné à partir d'une première ligne de source (30) desdites lignes de source d'alimentation ;
un deuxième niveau de courant de ligne échantillonné à partir d'une deuxième ligne de source (40) desdites lignes de source d'alimentation ; et
un troisième niveau de courant de ligne échantillonné à partir d'une troisième ligne de source (50) desdites lignes de source d'alimentation.

31. Procédé selon la revendication 30, dans lequel ledit sous-jeu de niveaux de courant comprend :

un premier niveau de courant de ligne échantillonné à partir d'une première ligne de source (30) desdites lignes de source d'alimentation ;

un deuxième niveau de courant de ligne échantillonné à partir d'une deuxième ligne de source (40) desdites lignes de source d'alimentation ; et

un troisième niveau de courant de ligne échantillonné à partir d'une troisième ligne de source (50) desdites lignes de source d'alimentation.

**32.** Procédé selon la revendication 20, comprenant de plus l'échantillonnage d'une pluralité de jeux de niveaux de tension et de courant à une fréquence d'échantillonnage prédéterminée sur un intervalle de temps prédéterminé afin de générer un jeu de valeurs de données de facteur de puissance triphasée instantané.

**33.** Procédé selon la revendication 32, dans lequel la fréquence d'échantillonnage est sélectionnée de façon à distribuer les emplacements d'échantillon dans la période de cycle de ligne et à produire un échantillonnage de représentation de valeurs de facteur de puissance instantané.

**34.** Procédé selon la revendication 32, comprenant de plus la génération d'une valeur de données de facteur de puissance triphasée réel par filtrage dudit jeu de valeurs de données de facteur de puissance triphasée instantané.

**35.** Procédé selon la revendication 20, comprenant de plus l'échantillonnage d'une pluralité de jeux de niveaux de tension et de courant à une fréquence d'échantillonnage prédéterminée de façon à générer de façon continue une pluralité correspondante de valeurs de données de facteur de puissance triphasée instantané.

**36.** Procédé selon la revendication 35, comprenant de plus la vérification continue du fait que chacune d'un nombre consécutif prédéterminé de valeurs de données les plus récentes de ladite pluralité correspondante de valeurs de données de facteur de puissance triphasée instantané est inférieure ou égale à zéro, ou, autrement dit, non positive.

**37.** Procédé selon la revendication 36, comprenant de plus la déclaration d'une détection d'une condition de perte de puissance momentanée si chacune dudit nombre consécutif prédéterminé de valeurs de données les plus récentes de ladite pluralité correspondante de valeurs de données de facteur de puissance triphasée instantané est inférieure ou égale à zéro, ou, autrement dit, non positive.

**38.** Procédé selon la revendication 37, comprenant de plus l'ordre du fait qu'une charge dudit système de puissance triphasé soit au moins temporairement déconnectée desdites lignes de source d'alimentation lorsque ladite détection de ladite condition de perte de puissance momentanée est déclarée.

**39.** Procédé selon la revendication 20, dans lequel l'étape d'échantillonnage comprend les étapes consistant à :

déterminer trois jeux de courants respectivement associés à trois phases de moteur ;
déterminer trois jeux de tensions respectivement associés à trois phases de moteur ;
et dans lequel l'étape de génération comprend les étapes consistant à :

calculer des phaseurs de courant et des phaseurs de tension à partir des jeux de courants et des jeux de tensions ; et
déterminer un facteur de puissance instantané à partir des phaseurs de courant et de tension calculés.

**40.** Procédé selon la revendication 39, comprenant l'étape supplémentaire de réalisation d'une moyenne du facteur de puissance instantané sur un cycle de ligne afin de déterminer un facteur de puissance.

**41.** Appareil selon la revendication 1, comprenant de plus :

des moyens pour déterminer trois jeux de courants respectivement associés à trois phases de moteur ;
des moyens pour déterminer trois jeux de tensions respectivement associés à trois phases de moteur ;
des moyens pour calculer des phaseurs de courant et des phaseurs de tension à partir des jeux de courants et des jeux de tensions ; et
des moyens pour déterminer un facteur de puissance instantané à partir des phaseurs de courant et de tension calculés.

**42.** Agencement selon la revendication 41, comprenant de plus des moyens pour réaliser une moyenne du facteur de puissance instantané sur un cycle de ligne afin de déterminer un facteur de puissance.

TYPICAL LINE SIDE CONFIGURATION

FIG 1

FIG. 2

FIG 3

VOLTAGE & CURRENT MAGNITUDES

CALCULATE INSTANTE-
OUS 3-PHASE POWER
FACTOR USING MOST RE
-CENT SAMPLES OF CUR-
RENT & VOLTAGE SIGNALS ~ 250

POWER FACTOR POSITIVE ? ~ 260

YES

NO

POWER FACTOR BEEN NON POSITIVE SIX CONSECUTIVE TIMES ? ~ 270

NO

YES

MOMENTARY POWER LOSS DETECTED ~ 280

~ 290

EXIT

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4751653 A, Junk
- US 4802053 A, Wojtak
- US 5058031 A, Swanson
- US 5184063 A, Eisenhauer
- US 5200682 A, Kim
- US 5469045 A
- EP 0498953 A